# EUROPÄISCHE PATENTSCHRIFT

(11) **EP 3 096 362 B1**
(45) Veröffentlichungstag und Bekanntmachung des Hinweises auf die Patenterteilung: **18.04.2018**
(21) Anmeldenummer: 16166948.6
(22) Anmeldetag: 25.04.2016
(51) Int. Cl.: H01L 31/105, G02B 6/42

(54) **HOCHGESCHWINDIGKEITS-GERMANIUM-PIN-FOTODIODE**
HIGH-SPEED GERMANIUM PIN PHOTODIODE
PHOTODIODE PIN RAPIDE EN GERMANIUM

(30) Priorität: 24.04.2015 DE 102015207618; 30.06.2015 DE 102015212208
(43) Veröffentlichungstag der Anmeldung: 23.11.2016
(73) Patentinhaber: IHP GmbH-Innovations for High Performance Microelectronics / Leibniz-Institut für innovative Mikroelektronik, 15236 Frankfurt / Oder (DE)
(72) Erfinder: KNOLL, Dieter, 15230 Frankfurt (Oder) (DE); LISCHKE, Stefan, 15232 Frankfurt (Oder) (DE)
(74) Vertreter: Eisenführ Speiser

(56) Entgegenhaltungen:
- DE-A1-102013 201 644
- US-A1- 2013 071 058
- US-A1- 2015 016 769
- US-A1- 2015 069 565
- KNOLL D ET AL: "High-performance photonic BiCMOS process for the fabrication of high-bandwidth electronic-photonic integrated circuits", 2015 IEEE INTERNATIONAL ELECTRON DEVICES MEETING (IEDM), IEEE, 7. Dezember 2015 (2015-12-07), XP032865564, DOI: 10.1109/IEDM.2015.7409706 [gefunden am 2016-02-16]

## Beschreibung

Die Erfindung betrifft eine Diode mit einem lichtempfindlichen Germaniumgebiet.

Optische und optoelektronische Komponenten, hergestellt mit einer Silizium-basierten Technologie, sind Schlüsselbausteine z. B. für optische Telekommunikation oder optische Verbindungen in oder zwischen mikroelektronischen Schaltungen. Beispiele solcher Komponenten sind Koppler, Wellenleiter, Modulatoren und insbesondere Fotodetektoren.

Moderne Fotodetektoren nutzen Germanium (Ge) als Detektormaterial auf Grund seines deutlich besseren Absorptionsvermögens gegenüber Silizium im für optische Kommunikation genutzten Wellenlängenbereich (λ = 1,3 - 1,6 µm). Oftmals wird als Detektor eine sogenannte PIN-Diode genutzt. Dabei steht "P" für ein p-dotiertes Gebiet, "I" für ein intrinsisches Gebiet und "N" für n-dotiertes Halbleitergebiet. Wichtige Parameter der Diode sind Dunkelstrom, Fotostrom, Empfindlichkeit und optische Bandbreite.

Mit einer Weite des intrinsischen Gebiets von einigen hundert Nanometern wurden schon sehr schnelle Ge-Fotodioden mit einer optischen Bandbreite von 50 GHz und mehr demonstriert.

Typischerweise werden Ge-Fotodioden durch epitaktisches Wachstum einer Ge-Schicht direkt auf einem SOI-Substrat hergestellt, was eine direkte Ankopplung des Detektors an einen Wellenleiter gestattet, der aus der oberen, einkristallinen Silizium-Schicht der SOI-Struktur hergestellt wird. Dadurch kann das zu detektierende Licht parallel zur Wellenleiter-Dioden-Grenzfläche zugeführt werden, was eine in gewissen Grenzen unabhängige Dioden-Optimierung hinsichtlich Empfindlichkeit und optischer Bandbreite erlaubt.

Die Kontaktierung der Dioden erfolgt meist in der Art, dass das Kontaktmetall direkt hochdotierte Ge-Gebiete berührt, die seitlich oder vertikal an das intrinsische Ge-Gebiet anschließen. Das führt zu Verlusten infolge von Lichtabsorption durch die MetallElektroden und infolge von Lichtabsorption durch freie Ladungsträger in den dotierten Ge-Gebieten, was die Empfindlichkeit der Dioden begrenzt.

Um solche Verluste zu vermeiden, wurde in der Veröffentlichung Yi Zhang, Shuyu Yang, Yisu Yang, Michael Gould, Noam Ophir, Andy Eu-Jin Lim, Guo-Qiang Lo, Peter Magill, Keren Bergman, Tom Baehr-Jones, and Michael Hochberg; "A high-responsivity photodetector absent metal-germanium direct contact"; 5 May 2014, Vol. 22, No. 9, DOI:10.1364/OE.22.011367, OPTICS EXPRESS 11367-11375, nachfolgend mit [1] bezeichnet, eine Fotodiode vorgestellt, die hochdotierte Ge-Gebiete vermeidet und deren Kontaktierung mit Metall über dotierte, nicht-absorbierende Silizium-Gebiete erfolgt, die das absorbierende, intrinsische Ge-Gebiet von unten berühren. Nachteil dieser bekannten Fotodiode ist, dass sowohl eine hohe Empfindlichkeit als auch eine hohe Bandbreite erst bei sehr hohen Betriebsspannungen > 4 V erreicht werden.

Dieser Nachteil wurde bei einer in der Veröffentlichung S. Sahni, N.K. Hon, and G. Masini; "The Dual-Heterojunction Ge on Si Photodetector"; ECS Transactions, Vol. 64, issue 6, pp. 783-789, nachfolgend [2], vorgeschlagenen Ge-PIN-Fotodiode, allerdings unter Inkaufnahme einer relativ geringen Bandbreite von weniger als 50 GHz gemildert.

Die Dokumente US2015/0016769 und DE102013201644 offenbaren andere Alternativen von Ge-PIN-Wellenleiterphotodioden.

Zusammenfassend sind bisher keine Ge-PIN-Fotodioden bekannt, die Bandbreiten von deutlich mehr als 50 GHz zusammen mit einer Empfindlichkeit um 1A/W oder höher (für λ ∼1.55 µm) bei einer hinsichtlich Dunkelstrom und Beschaltung akzeptabel niedrigen Betriebsspannung, insbesondere einer Betriebsspannung von maximal - 2 V erreichen. Die Erfindung wird im Anspruch 1 definiert. Erfindungsgemäß wird eine Diode mit einem lichtempfindlichen Germanium-Gebiet vorgeschlagen, das sich auf einem Wellenleiter aus Silizium oder Siliziumgermanium befindet und das im Vergleich mit dem Wellenleiter identische oder um maximal 20 nm pro Seite kürzere laterale Abmessungen in einer Richtung quer zu einer Lichtausbreitungsrichtung im Wellenleiter hat, wobei
- die Diode im Germanium-Gebiet eine laterale Anordnung eines N-dotierten (also n-Typ), eines intrinsischen und eines P-dotierten (also p-Typ) Germanium-Gebiets enthält,
- die P-dotierten und die N-dotierten Germanium-Gebiete von einer Oberfläche des Germanium-Gebiets bis an eine Oberkante des Wellenleiters jeweils Dotierelemente aufweisen, an die optional zusätzlich darunter befindliche P- und N-dotierte Wellenleiter-Gebiete des Wellenleiters anschließen können, und sich P- und N-Dotierfronten, getrennt durch das intrinsische Gebiet, parallel gegenüberstehen,
- sich seitlich entweder nur an die P- und N-dotierten Gebiete im Germanium-Gebiet oder an die P- und N-dotierten Germanium-Gebiete und gegebenenfalls zusätzlich an die darunter befindlichen P- und N-dotierte Wellenleiter-Gebiete des Wellenleiters weitere homogen dotierte Ausläufer aus Silizium oder Siliziumgermanium jeweils gleichen Leitungstyps anschließen, die sich in vertikaler Richtung mindestens bis zu einem Niveau erstrecken, welches auf gleicher Höhe ist wie ein in der vertikalen Richtung höchster Punkt des Germanium-Gebiets.

Die erfindungsgemäß vorgeschlagene Diode beruht auf der Erkenntnis, dass eine Ursache für die Nachteile der aus [1] bekannten PIN-Fotodiode eine hinsichtlich des Verlaufes des elektrischen Feldes ungünstige Anordnung der beiden dotierten Si-Gebiete unterhalb des intrinsischen Ge-Gebietes ist. Sie beruht weiterhin auf der Erkenntnis, dass auch bei der in [2] beschriebenen Diode ein ungünstiger Feldverlauf vorliegt. Sie setzt zur Lösung dieser Problematik dabei an, eine Feldverteilung mit weitestgehend nicht gekrümmtem Feldverlauf zu ermöglichen. Dies wird durch die erfindungsgemäße Diode ermöglicht.

Die Struktur der Diode der vorliegenden Erfindung ermöglicht es, in Ausführungsformen eine Ge-PIN-Fotodiode bereitzustellen, die gleichzeitig eine sehr hohe optische Bandbreite und hohe optische Empfindlichkeit bei niedriger Betriebsspannung liefert. Sie kann also insbesondere die Nachteile der in [1] und [2] beschriebenen Dioden hinsichtlich erreichbarer Bandbreite vermeiden, ohne deren Vorteile in Bezug auf erreichbare Empfindlichkeit aufzugeben.

Bei einer solchen Ausführungsform enthält die Diode im Germanium-Gebiet eine laterale Abfolge eines N-dotierten, eines intrinsischen und eines P-dotierten Germanium-Gebiets, wobei die P-dotierten und die N-dotierten Germanium-Gebiete von einer Oberfläche des Germanium-Gebiets bis an eine Unterkante des Wellenleiters eine besonders bevorzugt, aber nicht notwendigerweise identische oder nahezu identische Konzentration von Dotierelementen aufweisen. P- und N-Dotierfronten, getrennt durch das intrinsische Gebiet, stehen sich bei dieser Ausführungsform parallel gegenüber. Damit wird eine sehr vorteilhafte Feldverteilung erreicht. Diese Ausführungsform liegt die Überlegung zugrunde, dass zur gleichzeitigen Erzielung einer hohen Bandbreite und einer hohen Empfindlichkeit bei kleinen Betriebsspannungen eine an einen Si- oder SiGe-Wellenleiter gekoppelte Ge-PIN-Diode einen möglichst nicht gekrümmten Verlauf des elektrischen Feldes im intrinsischen Ge-Gebiet aufweisen sollte. Um dies zu erreichen, stehen sich in der vorliegenden Ausführungsform die Übergangsflächen zwischen dotierten und intrinsischen Halbleitergebieten bei der vorliegenden Ausführungsform parallel gegenüber. Vorzugsweise ist auch kein Überstand von intrinsischen Gebieten zu den dotierten Gebieten in den Übergangsflächen gegeben.

Besonders vorteilhaft hinsichtlich der Feldverteilung ist, dass sich seitlich entweder nur an die P- und N-dotierten Gebiete im Germanium-Gebiet oder an die P- und N-dotierten Germanium-Gebiete und gegebenenfalls zusätzlich an die darunter befindlichen P- und N-dotierten Wellenleiter-Gebiete des Wellenleiters weitere homogen dotierte Ausläufer aus Silizium oder Siliziumgermanium jeweils gleichen Leitungstyps wie das unmittelbar benachbarte Germanium-Gebiet anschließen, die sich in vertikaler Richtung mindestens bis zu einem Niveau erstrecken, welches auf gleicher Höhe ist wie ein in der vertikalen Richtung höchster Punkt des Germanium-Gebiets. Das Ge-Gebiet wird also seitlich mit Silizium oder Siliziumgermanium bedeckt und ermöglicht so die Kontaktierung des Ge-Gebietes über die an das Ge-Gebiet seitlich angrenzenden, unterschiedlich dotierten Ausläufer.

Nachfolgend werden Ausführungsformen der erfindungsgemäßen Diode erläutert.

Der Wellenleiter steht in manchen Ausführungsformen ein kleines Stück über die laterale Erstreckung des über ihm liegenden Germanium-Gebiets hinaus, und zwar pro Seite, also am Beispiel der in den beiliegenden Figuren gezeigten Schnittansichten links und rechts des Germaniumgebiets, jeweils maximal 20 Nanometer

Die Eigenschaften der Diode werden in einer Ausführungsform weiter verbessert, bei der in Feldrichtung die Abmessungen der P- und N-dotierten Ge-Gebiete klein gegenüber der Abmessung des intrinsischen Ge-Gebietes sind. Vorzugsweise betragen die Abmessungen der P- und N-dotierten Ge-Gebiete in Feldrichtung jeweils weniger als 50% der Abmessung des intrinsischen Ge-Gebietes. Besonders bevorzugt betragen die Abmessungen der P- und N-dotierten Ge-Gebiete weniger als 30% der Abmessung des intrinsischen Ge-Gebietes. Besonders bevorzugt betragen die Abmessungen der P- und N-dotierten Ge-Gebiete jedoch mindestens 5%, in einer anderen Ausführungsform mindestens 10% der Abmessung des intrinsischen Ge-Gebietes.

Die Feldverteilung wird in einer Variante weiter verbessert, bei der sich die P- und N-Dotierfronten über das Germanium-Gebiet hinaus in Richtung des Substratinneren, also vertikal nach unten, bis zur Unterkante des Wellenleiters fortsetzen und P- und N-dotierte Wellenleiter-Gebiete von einem intrinsischen Wellenleitergebiet trennen.

Bei einer weiteren Ausführungsform erstrecken sich die Ausläufer in seitlicher Richtung vom Germanium-Gebiet bis zu einem von einem Isolator begrenzten (äußeren) Dioden-Rand und liegen auf einer Silizium-Oxid-Schicht auf. Dieses Ausführungsbeispiel ermöglicht es vorteilhafterweise, einen direkten Kontakt zwischen Metallgebieten und dem Ge-Gebiet zu vermeiden. So können in einer hierauf basierenden Ausführung Metall-Silizid-Schichten zumindest horizontal, also in seitlicher Richtung verlaufende Schichtteile der Ausläufer bedecken, ohne mit dem Ge-Gebiet in direktem Kontakt zu sein. Der damit erreichbare niedrige Kontaktwiderstand zu den dotierten Si-oder SiGe-Gebieten kommt dem Hochfrequenzverhalten der Diode zugute. Die Dicke des die Ausläufer bildenden Silizium- oder Siliziumgermanium-Schichtabschnittes seitlich des Ge-Gebietes hat in verschiedenen alternativen Ausführungsformen einen Wert zwischen 20 und 300 nm.

Vorzugsweise sind zusätzlich vertikal verlaufende Metallverbindungen enthalten, die die Metall-Silizid-Schichten mit Metallstrukturen verbinden, die in einer ersten horizontalen strukturierten Metallebene angeordnet sind und das Anlegen einer Betriebsspannung an die Diode ermöglichen.

Von oben her kann das Ge-Gebiet mit verschiedenen Schicht-Stapeln bedeckt sein, worauf nachfolgend im Kontext weiterer Ausführungsformen näher eingegangen wird.

In vorteilhaften Ausführungsformen ist das Germanium-Gebiet von einer Silizium-Schicht bedeckt. Diese hat vorzugsweise eine Schichtdicke im Bereich zwischen 20 nm und 150 nm.

In anderen Ausführungsformen ist die Diode direkt oberhalb des intrinsischen Germanium-Gebiets oder eines daran nach oben hin anschließenden intrinsischen Silizium-Gebiets der Silizium-Schicht mit einem Isolator-Schicht-Streifen bedeckt. Die Dicke des Isolator-Schicht-Streifens beträgt in unterschiedlichen Varianten dieser Ausführungsformen zwischen 50 nm und 500 nm.

In manchen dieser Ausführungsformen ist die laterale Abmessung des Isolator-Schicht-Streifens gleich oder bis zu etwa 50 % geringer als die gesamte laterale (also seitliche) Ausdehnung des lichtempfindlichen Germanium-Gebietes, wobei ein seitlicher Überstand des Germanium-Gebiets gegenüber dem Isolator-Schicht-Streifen auf beiden Seiten vorzugsweise zumindest annähernd gleich ist. Das Germanium-Gebiet ist in einigen solcher Ausführungsformen pro Seite etwa 200 nm breiter als der Isolator-Schicht-Streifen. Bei einer vertikalen Schichtstreifendicke von typischerweise mehr als 300 nm erlaubt die Verwendung eines solchen Isolator-Schicht-Streifens auf der Dioden-Oberseite eine selbstjustierte Implantation von Dotierelementen zur Herstellung der P- und N-dotierten Gebiete der PIN-Struktur. Vorteilhafterweise sind dabei ImplantationsBedingungen zu wählen, die zu einer homogenen Dotierung des gesamten Si-Ge-(Si)-Schichtstapels in vertikaler Richtung führen, was für das Erzielen eines weitestgehend nicht-gekrümmten Verlaufes des elektrischen Feldes im intrinsischen Ge-Gebiet einen weiteren Beitrag liefert.

Durch die Verwendung des Isolator-Streifens wird sogar eine selbstjustierte Silizid-Bildung ermöglicht, ähnlich oder sogar identisch zu der, die in CMOS- oder BiCMOS-Prozessen typischerweise für Transistoren angewandt wird.

Hierfür kann jedoch der Isolator-Schicht-Streifen in anderen Ausführungsformen auch breiter sein als das Germanium-Gebiet, beispielsweise um bis zu 50% breiter, in einer Variante bis 200 nm pro Seite des Germanium-Gebiets breiter.

An den Isolator-Schicht-Streifen schließen seitlich vorzugsweise Abstandshalter (Spacer) aus einem isolierenden Material, beispielsweise aus Silizium-Nitrid an, mit deren Hilfe ein Abstand zwischen dem Isolator-Schichtstreifen und den Metall-Silizid-Schichten definierbar ist.

Durch Abstimmung der Breiten des Isolator-Schicht-Streifens und des Ge-Gebietes kann eine Dioden-Struktur gebildet werden, die praktisch nur horizontale Übergänge zwischen dotierten und intrinsischen Ge-Gebieten über die ganze vertikale Ausdehnung des Ge-Gebietes aufweist und damit eine Krümmung des elektrischen Feldes innerhalb des intrinsischen Ge-Gebietes weitestgehend vermeidet. Zusätzlich kann dies durch Abstimmung des Verhältnisses der lateralen Ausdehnung dotierter zu undotierter Ge-Gebiete begünstigt werden.

Anwendung findet die erfindungsgemäße Diode oder eine ihrer hier beschriebenen Ausführungsformen vorteilhafterweise als Fotodiode.

Eine Weiterbildung der Diode bildet ein optoelektronisches Bauelement, welches eine Diode gemäß der Erfindung oder einer ihrer Ausführungsformen und eine weitere optischen oder optoelektronischen Komponente enthält, vorzugsweise monolithisch in integrierter Form. Diese steht vorzugsweise über den Wellenleiter mit der Diode in optischer Kommunikation.

Die weitere optische oder optoelektronische Komponente ist in unterschiedlichen Ausführungsformen mindestens ein Lichtemitter, mindestens ein Koppler zur Ein- oder Auskopplung von Licht in den Wellenleiter, mindestens ein Lichtmodulator ist oder eine Kombination mindestens zweier der genannten Komponenten ist.

Eine gesamte Höhe der Diode über der unteren Ge-Si-Grenzfläche beträgt vorzugsweise höchstens 700 nm, in besonders bevorzugten Ausführungsformen höchstens 500 nm, wobei diese Höhe eine maximale Dicke des Ge-Gebiets über der unteren Grenzfläche und eine Dicke einer gegebenenfalls (aber nicht notwendigerweise) vorhandenen Silizium-Schicht über dem Germanium-Gebiet einschließt. Gegebenenfalls wird die gesamte Höhe der Diode also in vertikaler Richtung von einer unteren Grenzfläche zwischen dem Germanium-Gebiet und dem darunter liegendem Wellenleiter bis zu einer vom Germanium-Gebiet abgewandten Oberseite der es bedeckenden Silizium-Schicht gemessen, Mit einer totalen Höhe des Detektors von nicht mehr als 500 - 700 nm, gemessen von der unteren Grenzfläche, wird hauptsächlich den Anforderungen üblicher, CMP(chemisch-mechanisches Polieren)-basierter Mehrebenen-Metallisierungssysteme Rechnung getragen.

Die tatsächliche Höhe der Diode kann entweder durch direktes Wachstum auf die bevorzugte Schichtdicke eingestellt werden, oder, um geringere Versetzungsdichten zu erreichen, durch Aufbringen einer zunächst dickeren Ge-Schicht, die nachfolgend durch Rückätzung oder CMP auf die Zieldicke gebracht wird.

Das Ge-Gebiet weist bei einer bevorzugten Ausführung als PIN-Diode einen nur intrinsisch leitfähigen, also nicht absichtlich dotierten Abschnitt auf, der sich unterhalb eines auf der Si-Schicht, die das Ge-Gebiet von oben abdeckt, oder direkt auf der Ge-Schichtoberfläche angeordneten Isolator-Schicht-Streifens erstreckt, dessen laterale Ausdehnung bei der Herstellung der Diode die laterale Ausdehnung des intrinsischen Gebietes der Diode zumindest im Wesentlichen bestimmt.

Seitlich an den intrinsisch leitfähigen Abschnitt des Ge-Gebietes schließen in Weiterbildungen der Ausführung als PIN-Diode dotierte Ge- und Si-Gebiete an, die sich lateral vom intrinsischen Ge-Gebiet der Diode bis zu einem typischerweise von einem Isolator begrenzten Dioden-Rand erstrecken. Steile Dotierungsprofile sind förderlich für hohe optische Bandbreite der Fotodiode.

Im Folgenden werden die Merkmale und Vorteile der erfindungsgemäßen PIN-Fotodiode anhand der Figuren näher erläutert.

Es zeigen:
Figur 1 eine erste Ausführungsform einer erfindungsgemäßen PIN-Fotodiode in einer Querschnittsansicht;
Figur 2 ein erstes Verfahrensstadium eines Ausführungsbeispiels eines Herstellungsverfahrens für die PIN-Fotodiode der Figur 1 in einer Querschnittsansicht;
Figur 2a eine Draufsicht zum Verfahrensstadium der Figur 2;
Figur 3 bis 11 nachfolgende Verfahrensstadien des Ausführungsbeispiels eines Herstellungsverfahrens für die PIN-Fotodiode der Figur 1 in jeweiligen Querschnittsansichten;
Figur 12 bis 21 Verfahrensstadien eines Ausführungsbeispiels eines Herstellungsverfahrens für eine in Figur 21 dargestellte PIN-Fotodiode in jeweiligen Querschnittsansichten;
Figur 22 eine elektronenmikroskopische Querschnittsansicht einer PIN-Diode, die in ihrer Struktur dem in Fig. 1 schematisch dargestellten Ausführungsbeispiel entspricht; und
Figur 23 bis 25 an einer Dioden-Struktur gemäß Figur 22 aufgenommene Messdaten.

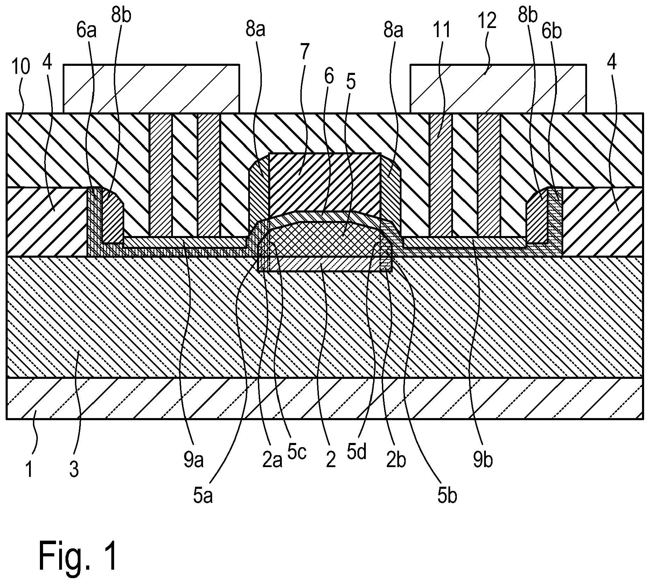

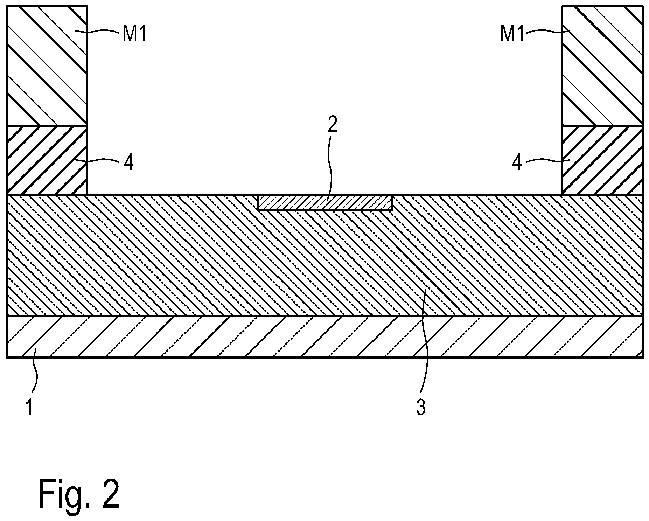

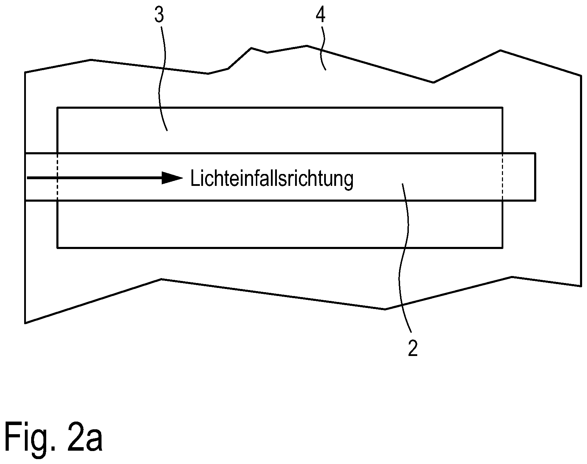

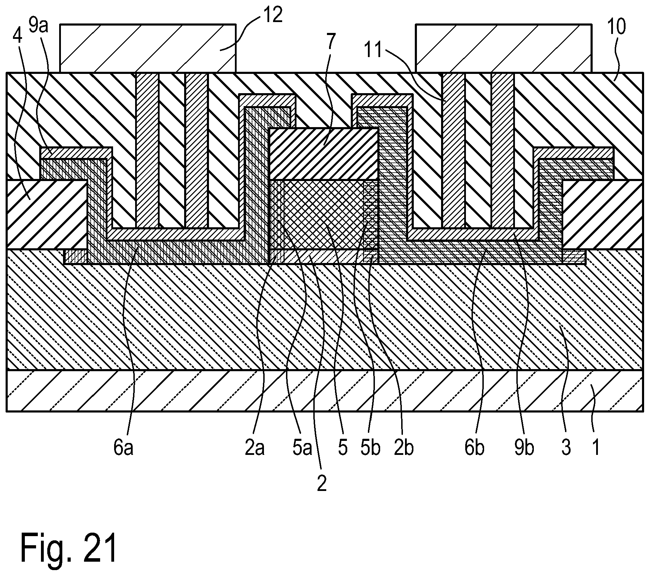

Zunächst werden nachfolgend anhand der Figuren 1 und 21 zwei Ausführungsformen einer erfindungsgemäßen PIN-Fotodiode beschrieben. Diese Figuren zeigen, wie auch alle anderen Figuren, mit Ausnahme von Figur 2a, Strukturquerschnitte senkrecht zur Einfallsrichtung des Lichtes.

Die Figuren 2 bis 20 illustrieren dann, anhand schematischer Darstellungen unterschiedlicher Prozessstadien, zwei Beispiele von Herstellungsprozessen dieser Ausführungsformen der erfindungsgemäßen PIN-Fotodiode und deren Merkmale.

Figur 1 illustriert eine erste Ausführungsform einer erfindungsgemäßen PIN-Fotodiode. Auf einem einkristallinen Silizium-Wellenleiter, der aus den P- und N-dotierten Gebieten 2a und 2b sowie dem intrinsischen Gebiet 2 besteht und von unten und seitlich mit einer Siliziumdioxid-Schicht 3 umrahmt ist, die vertikal an ein Silizium-Substrat 1 angrenzt, befindet sich eine Germanium-Schicht, die die dotierten Gebiete 5a und 5b sowie das intrinsische Gebiet 5 enthält. Diese Ge-Schicht ist mit einer Silizium-Schicht bedeckt, die aus den dotierten Gebieten 6a und 6b und einem nichtdotierten Gebiet 6 besteht. Wesentlich für die erfindungsgemäße PIN-Fotodiode ist, dass der Si-Wellenleiter unterhalb der Ge-Schicht diese lateral nicht überragt. Die gesamte Dioden-Struktur wird seitlich von einer Isolator-Schicht 4, vorzugsweise einer Silizium-Oxid-Schicht umhüllt. Weiterhin ist die Dioden-Struktur mit einem Isolator-Schichtstreifen 7 bedeckt, der, wie unten noch näher erläutert wird, eine zu den P- und N-dotierten Gebieten 2a, 2b, 5a, 5b, 6a und 6b selbstjustierte Herstellung der intrinsischen Gebiete 2, 5 und 6 ermöglicht. Die seitlichen Isolator-Schicht-Spacer 8a und 8b, die gleichzeitig ausgebildet werden, sind optional. Die Spacer 8a erhöhen die Sicherheit bei der Vermeidung unerwünschter Dioden-Leckströme, welche durch ungewollte Berührung von den auf den dotierten Gebieten 6a und 6b ausgebildeten Metall-Silizid-Schichten 9a und 9b mit dem intrinsischen Si-Gebiet 6 auftreten würden.

Figur 21 illustriert eine zweite Ausführungsform einer erfindungsgemäßen PIN-Fotodiode. Sie unterscheidet sich von der anhand Figur 1 illustrierten Ausführungsform vor allem durch zwei Details, dem Fehlen des nichtdotierten Si-Gebietes 6 und dem Fehlen der seitlichen Isolator-Schicht-Spacer 8a. Diese Spacer können in dieser Ausführungsform auf jeden Fall weggelassen werden, da durch gleichzeitiges Fehlen des nichtdotierten Si-Gebietes 6 der für die erste Ausführungsform angedeutete Leckstrom-Mechanismus völlig vermieden wird. Potentieller Vorteil dieser Ausführungsform im Vergleich zur ersten ist ein reduzierter Serienwiderstand durch Erhöhung des Metall-Silizid-Bedeckungsgrades über dotierten Si-Gebieten, was hinsichtlich Bandbreite nützlich ist.

Nachfolgend werden anhand der Figuren 2 bis 11 bzw. 12 bis 20 Herstellungs-Prozesse der ersten und zweiten Ausführungsform der erfindungsgemäßen PIN-Fotodiode beschrieben.

Figur 2 zeigt den Zustand des Gebietes, in dem nachfolgend die Germanium PIN-Diode hergestellt wird, nach Herstellung eines Si-Wellenleiters 2 und der nachfolgenden Ätzung eines Fensters in eine Isolator-Schicht 4 mittels einer Lackmaske M1. Wellenleiter 2 und Siliziumdioxid-Schicht 3, die sich auf einem Si-Substrat 1 befindet, bilden nach Ätzen von Schicht 4 innerhalb des geätzten Fensters eine weitestgehend ebene Oberfläche. Wesentlich ist, dass das geätzte Fenster den Wellenleiter 2 auf beiden Seiten überragt. Angemerkt sei, dass die Lage der Fensterränder zum Wellenleiter in Einfallsrichtung des Lichtes anders ist, wie in einer Draufsicht in Figur 2a illustriert.

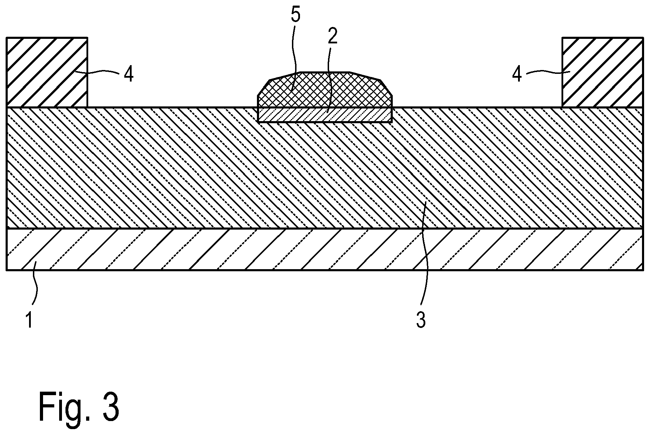

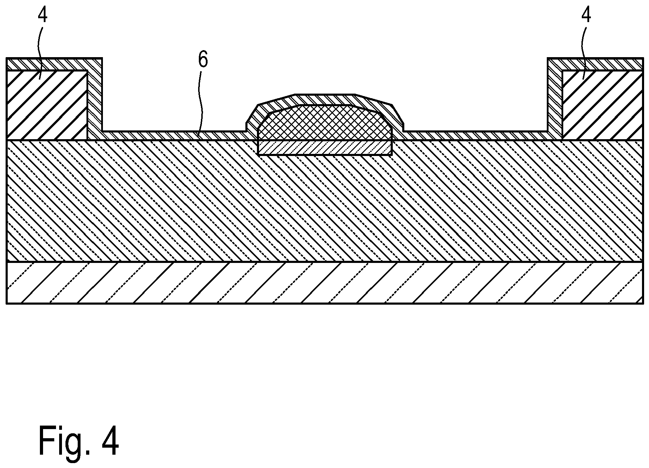

Figur 3 zeigt das Stadium des Herstellungs-Prozesses der Diode nach selektivem, epitaktischen Wachstum einer nichtdotierten Germanium-Schicht 5 auf dem Si-Wellenleiter. Die für selektives Ge-Wachstum auf (100)-orientiertem Silizium typische Facetten-Bildung auf der Schichtoberseite der Germanium-Schicht 5 ist schematisch angedeutet. Unmittelbar im Anschluss an das selektive Wachstum der Ge-Schicht erfolgt die nicht-selektive Abscheidung einer Silizium-Schicht 6, wie in Figur 4 illustriert.

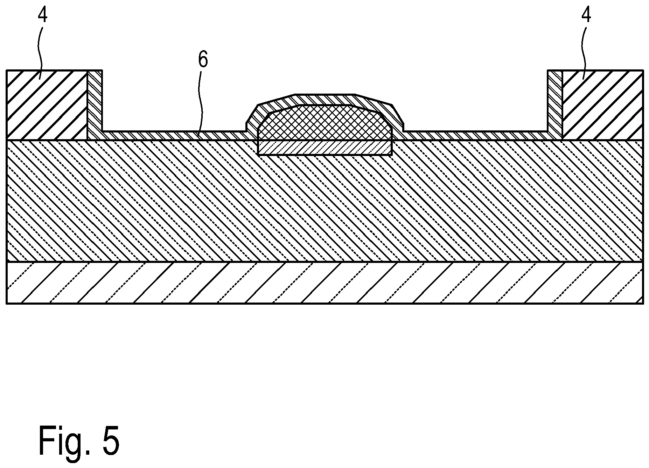

Figur 5 zeigt ein weiteres Stadium der Dioden-Herstellung. Mittels chemischmechanischem Polieren (CMP) wurden die Teile der Si-Schicht 6, die sich außerhalb des in Schicht 4 geätzten Fensters befanden, entfernt. Durch einen ausreichenden vertikalen Überstand der Isolator-Schicht 4 über den Teil der Si-Schicht 6, der im Inneren des Fensters die Ge-Schicht bedeckt, wird dessen Unversehrtheit während des CMP-Prozesses gewährleistet. Wesentlich für die angestrebten Dioden-Eigenschaften, insbesondere die hohe Empfindlichkeit, sind die sich nach CMP noch seitlich vom Ge-Gebiet im geätzten Fenster befindlichen Ausläufer der Si-Schicht 6, die für eine verlustarme Dioden-Kontaktierung genutzt werden können.

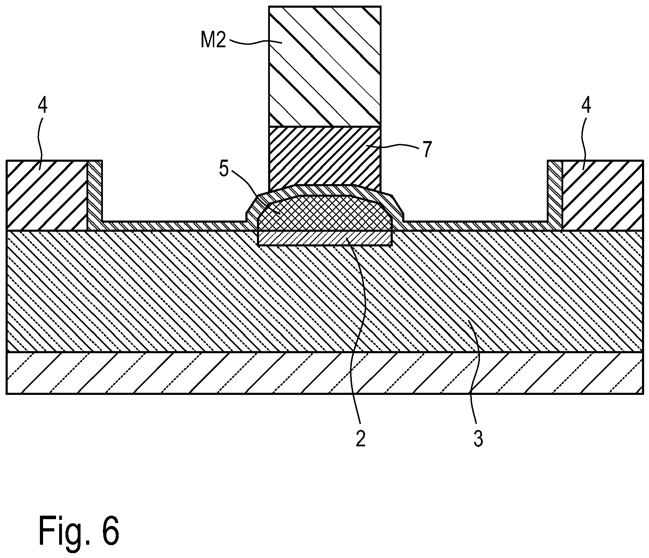

Figur 6 illustriert ein nächstes Stadium des Herstellungs-Prozesses der ersten Ausführungsform der erfindungsgemäßen PIN-Fotodiode. Mittels einer Lackmaske M2 wurde eine Isolator-Schicht geätzt. Maske M2 wurde dabei mit der üblichen Justier-Genauigkeit moderner Lithografie-Technik in seiner Lage zum Wellenleiter 2 und dem darüber liegenden Ge-Gebiet so zentriert wie möglich positioniert. Die Maskenbreite und, damit korreliert, die Breite des nach Ätzen verbleibenden Isolator-Schicht-Streifens 7 wird so gewählt, dass sie kleiner ist als die Breite des Wellenleiters 2. Die Höhe des Schichtstreifens 7 über dem Si-Gebiet 6 ist so gewählt, dass bei nachfolgenden Implantations-Schritten verhindert wird, dass Dotierungs-Elemente in senkrechter Richtung durch Streifen 7 hindurch in unter Streifen 7 gelegene Gebiete der Schichten 6 und 5 gelangen können. Auf diese Weise kann eine zueinander selbstjustierte Herstellung von dotierten und nicht-dotierten (intrinsischen) Si- und Ge-Gebieten realisiert werden.

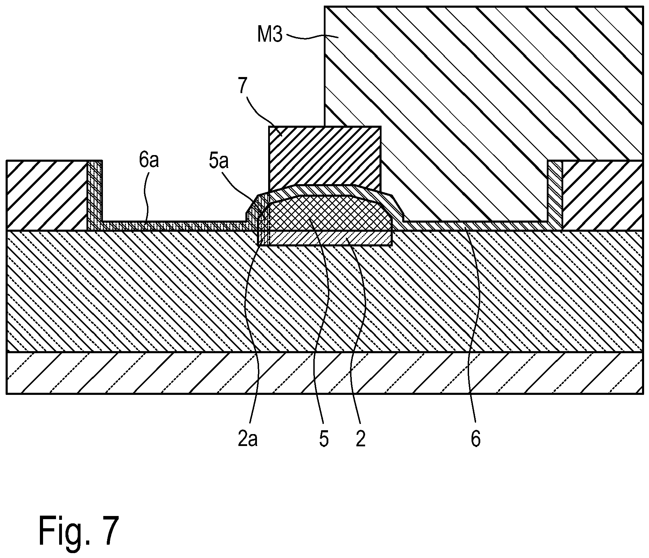

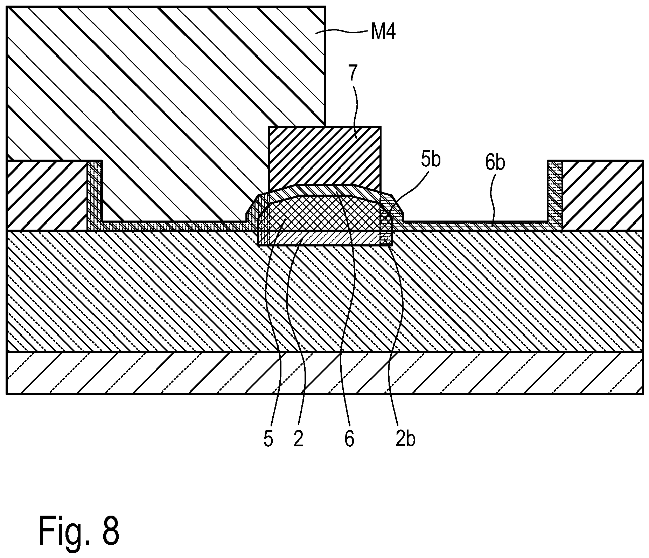

Figuren 7 und 8 illustrieren die Herstellung der P- und N-dotierten Gebiete der PIN-Dioden-Struktur unter Ausnutzung des vorher ausgebildeten Isolator-Schicht-Streifens 7 zur Selbstjustierung von dotierten zu intrinsischen Si- und Ge-Gebieten. Für die jeweiligen Implantationsschritte werden in der Halbleitertechnologie übliche Dotierungs-Elemente, wie z.B. Bor für P-Dotierung und Phosphor und Arsen für N-Dotierung, benutzt. Implantationsbedingungen wie Energien und Dosen werden dabei so gewählt, dass in senkrechter Richtung im gesamten implantierten Si-Ge-Si-Schichtstapel (2a, 5a und 6a bzw. 2b, 5b und 6b) eine nahezu homogene Dotierung erreicht wird, was für den angestrebten, weitestgehend nicht-gekrümmten Verlauf des elektrischen Feldes im verbleibenden intrinsischen Germanium-Gebiet 5 wesentlich ist.

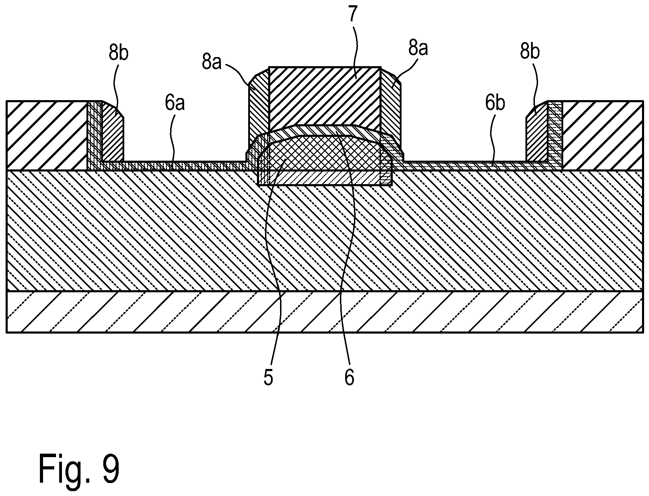

Das nächste Stadium der Herstellung der ersten Ausführungsform der erfindungsgemäßen PIN-Fotodiode ist in Figur 9 illustriert. Durch konforme Abscheidung einer Isolator-Schicht, vorzugsweise Silizium-Nitrid, und nachfolgendes anisotropes Ätzen dieser Schicht werden die Spacer 8a und 8b gebildet. Die Spacer 8a erhöhen die Sicherheit bei der Vermeidung unerwünschter Dioden-Leckströme, welche durch ungewollte Berührung von den auf den dotierten Gebieten 6a und 6b später ausgebildeten Metall-Silizid-Schichten mit dem intrinsischen Si-Gebiet 6 auftreten würden. Diese Spacer sind optional, weil nicht zwingend nötig. Ob sie gebildet werden müssen oder nicht, hängt z. B. von den konkreten thermischen Schritten ab, die der Dotierung durch Implantation im Herstellungsprozess gewöhnlich folgen und die, wenn sie zu einer gewissen seitlichen Unterdiffusion der Dotierelemente unter die Schicht 7 führen, die Bildung der Spacer überflüssig machen.

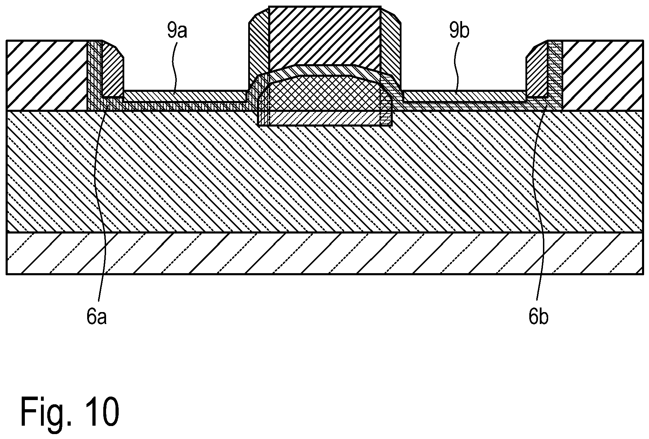

Die Bildung von Metall-Silizid-Schichten 9a und 9b auf den dotierten Si-Schichten 6a und 6b mittels in der Halbleitertechnologie üblichen Fertigungsschritten ist in Figur 10 illustriert. Die Schichten 9a und 9b dienen dem Erhalt eines niedrigen Serienwiderstandes der Dioden, der sich günstig auf die erreichbare Bandbreite auswirkt.

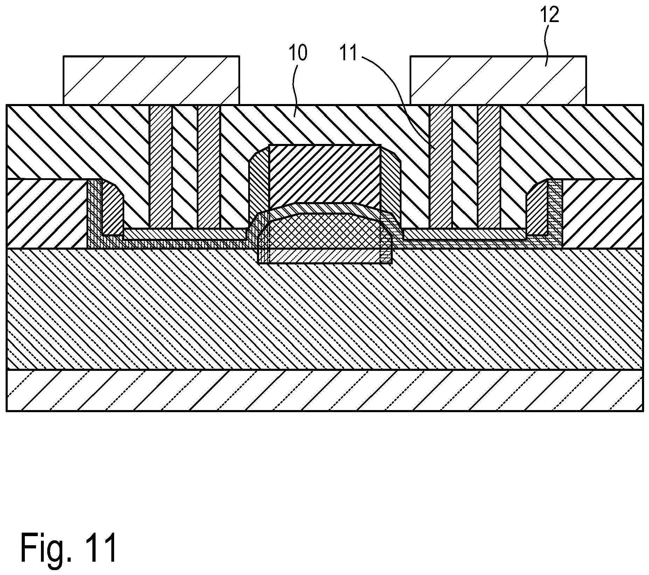

Das finale Stadium der Herstellung der ersten Ausführungsform der erfindungsgemäßen PIN-Fotodiode ist in Figur 11 illustriert. Senkrechte Metallverbindungen 11, vorzugsweise aber nicht notwendig aus hauptsächlich Wolfram bestehend, wurden mittels in der Halbleitertechnologie üblichen Fertigungsschritten in eine Isolator-Schicht 10 eingebaut. Anschließend erfolgte deren Verbindung mit einer ersten, strukturierten Metallschicht 12, vorzugsweise aber nicht notwendig aus hauptsächlich Aluminium bestehend. Die strukturierte Metallschicht 12 kann sofort zum Dioden-Betrieb genutzt werden. Genauso gut kann sie weiter mit höher liegenden, hier nicht gezeigten Metallschichten verbunden werden, was aber für die Erfindung unwesentlich ist.

Nachfolgend wird ein Herstellungsprozess der zweiten Ausführungsform der erfindungsgemäßen Ge-PIN-Fotodiode beschrieben.

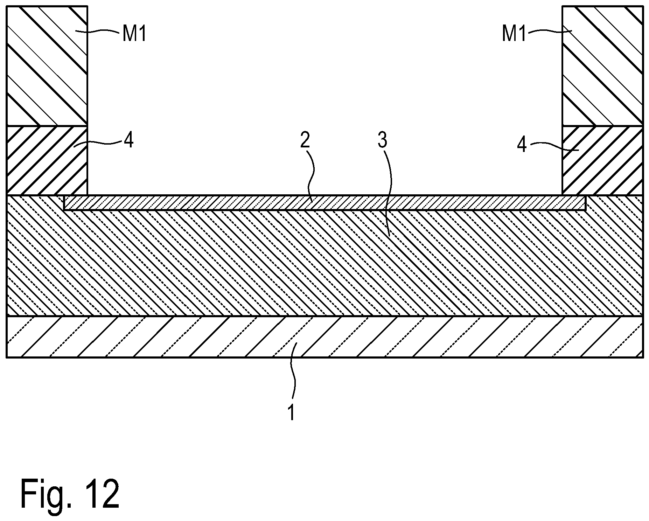

Figur 12 zeigt den Zustand des Gebietes, in dem nachfolgend die Germanium PIN-Diode hergestellt wird, nach Herstellung eines Si-Wellenleiters 2 und der nachfolgenden Ätzung eines Fensters in eine Isolator-Schicht 4 mittels einer Lackmaske M1. Im Unterschied zum Herstellungsprozess der ersten Ausführungsform (siehe Fig. 2) überragt hier der Wellenleiter 2 lateral auf beiden Seiten das in Schicht 4 geätzte Fenster.

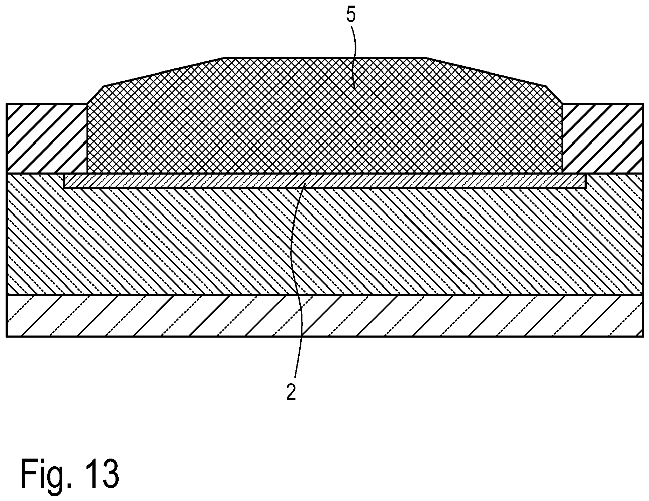

Figur 13 zeigt das Stadium des Herstellungs-Prozesses der Diode nach folgendem selektiven, epitaktischen Wachstum einer nichtdotierten Germanium-Schicht 5 auf dem Si-Wellenleiter 2. Im Unterschied zum Herstellungsprozess der ersten Ausführungsform (siehe Fig. 3) wird dabei eine Ge-Schichtdicke gewählt, die deutlich größer ist als die Dicke der Isolator-Schicht 4. Ziel ist, dass Facettenbildung unterhalb der Oberkante von Schicht 4 vermieden wird.

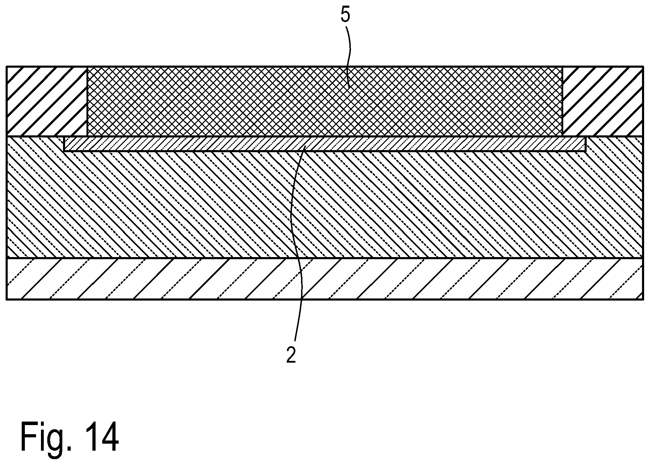

Figur 14 zeigt die Dioden-Struktur nach einem der Ge-Epitaxie folgenden Ge-CMP-Schritt, der zu einer nahezu ebenen Oberfläche der Schichten 4 und 5 führt.

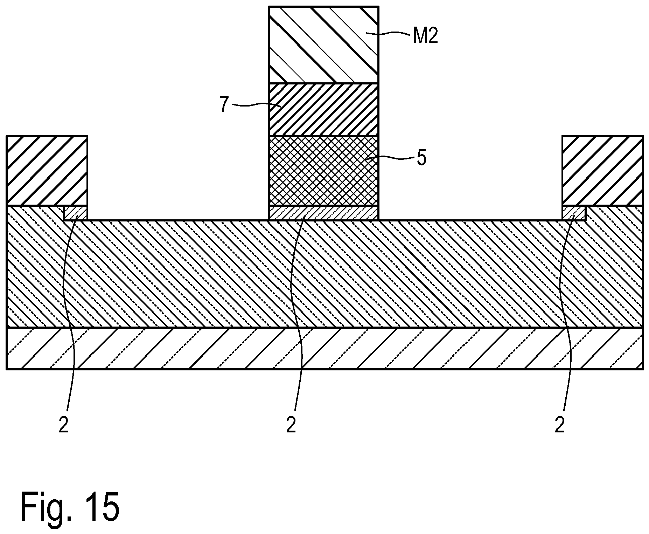

Figur 15 illustriert ein nächstes Stadium des Herstellungs-Prozesses der zweiten Ausführungsform der erfindungsgemäßen PIN-Fotodiode. Lackmaske M2 dient hier, im Unterschied zum Herstellungsprozess der ersten Ausführungsform (siehe Fig. 6), nicht nur zur Ätzung der Isolator-Schicht 7, sondern auch der darunterliegenden Ge-Schicht 5 und Si-Schicht 2. Maske M2 wurde dabei mit der üblichen Justier-Genauigkeit moderner Lithografie-Technik in seiner Lage zum Wellenleiter 2 und dem darüber liegenden Ge-Gebiet so zentriert wie möglich positioniert, wobei hier, im Vergleich zum Herstellungsprozess der ersten Ausführungsform, deutlich größere Justier-Toleranzen erlaubt sind. Wie im Falle des Herstellungsprozesses der ersten Ausführungsform, wird die Dicke des Schichtstreifens 7 so gewählt, dass bei nachfolgenden Implantations-Schritten verhindert wird, dass Dotierungs-Elemente in senkrechter Richtung durch Streifen 7 hindurch in unter Streifen 7 gelegene Gebiete der Schichten 5 und 2 gelangen können. Auf diese Weise kann eine zueinander selbstjustierte Herstellung von dotierten und nicht-dotierten (intrinsischen) Si- und Ge-Gebieten realisiert werden.

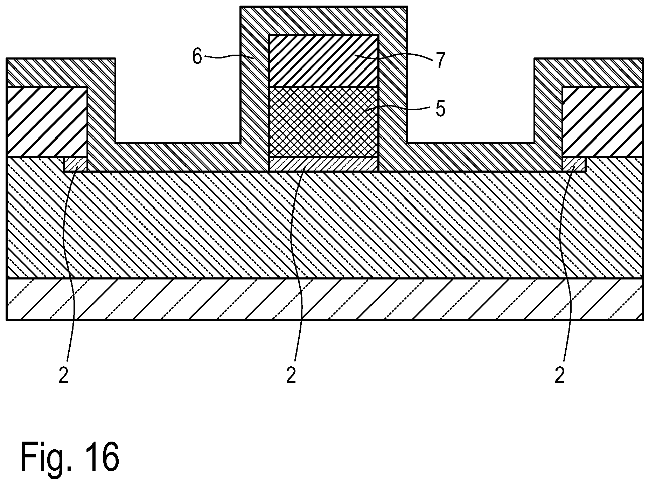

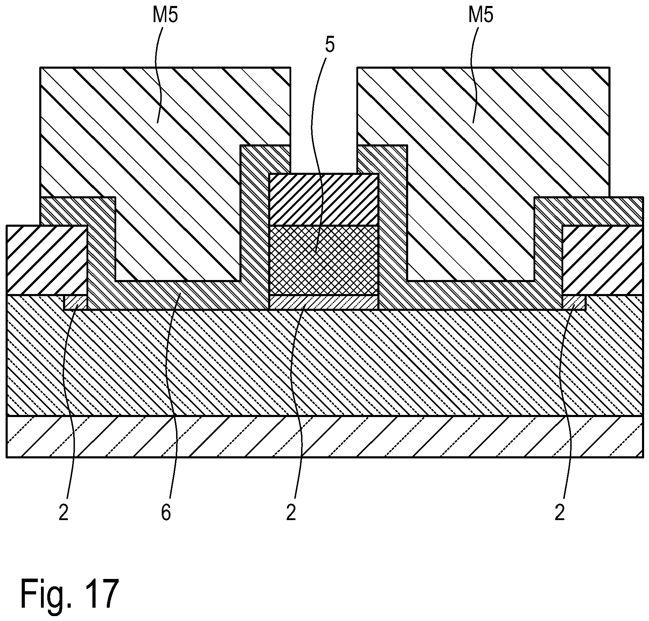

Nachfolgend erfolgt die Abscheidung einer Silizium-Schicht 6 und deren Strukturierung mittels Lackmaske M5, wie in den Figuren 16 und 17 illustriert. Anzumerken ist, dass Schicht 6 hier, im Unterschied zum Herstellungsprozess der ersten Ausführungsform (siehe z.B. Fig. 4), nur die Seitenwände der Ge-Schicht 5 berührt.

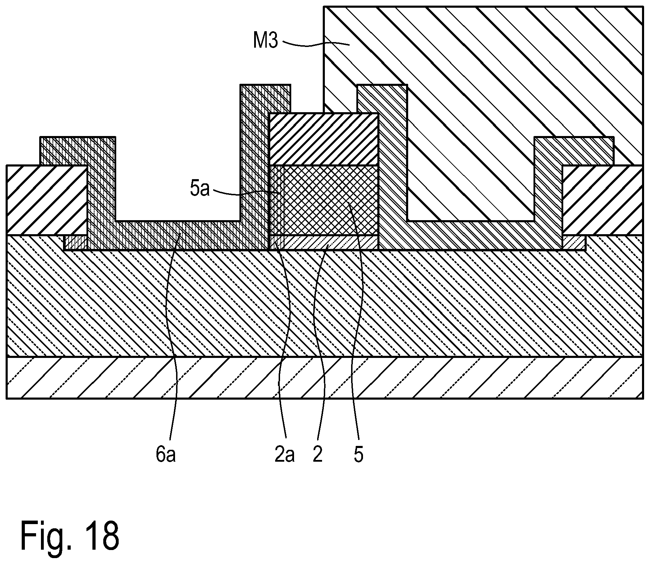

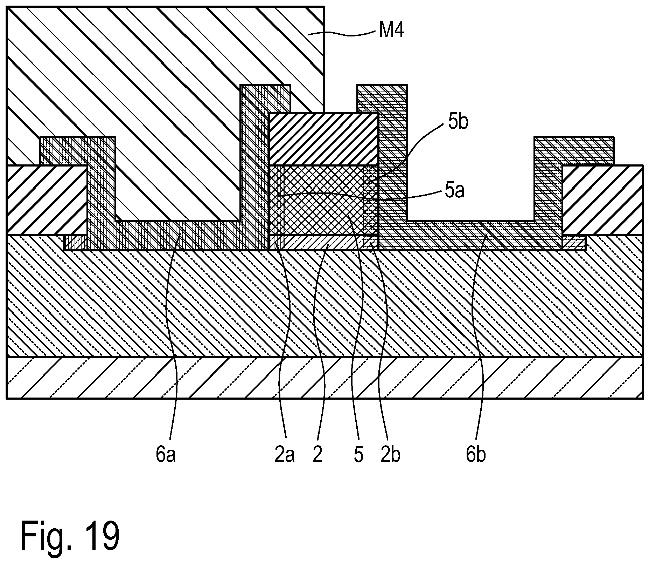

Figuren 18 und 19 illustrieren die Herstellung der P- und N-dotierten Gebiete 2a, 2b, 5a, 5b, 6a und 6b der PIN-Dioden-Struktur unter Ausnutzung des vorher ausgebildeten Isolator-Schicht-Streifens 7 zur Selbstjustierung von dotierten zu intrinsischen Si- und Ge-Gebieten. Zur Herstellung der dotierten Gebiete 2a, 2b, 5a und 5b wird die Implantation von Dotier-Elementen unter einem von der Senkrechten abweichenden Winkel ausgeführt und/oder laterale Ausdiffusion aus den Schichten 6a und 6b durch thermische Behandlung ausgenutzt. Wichtig ist hier wieder, wie im Falle des Herstellungsprozesses der ersten Ausführungsform, dass Prozessbedingungen für Implantation und nachfolgende thermische Schritte gewählt werden, die zu einer nahezu homogenen Dotierung in senkrechter Richtung in den Gebieten 2a und 5a bzw. 2b und 5b führen, was für den angestrebten, weitestgehend nicht-gekrümmten Verlauf des elektrischen Feldes im verbleibenden intrinsischen Germanium-Gebiet 5 wesentlich ist.

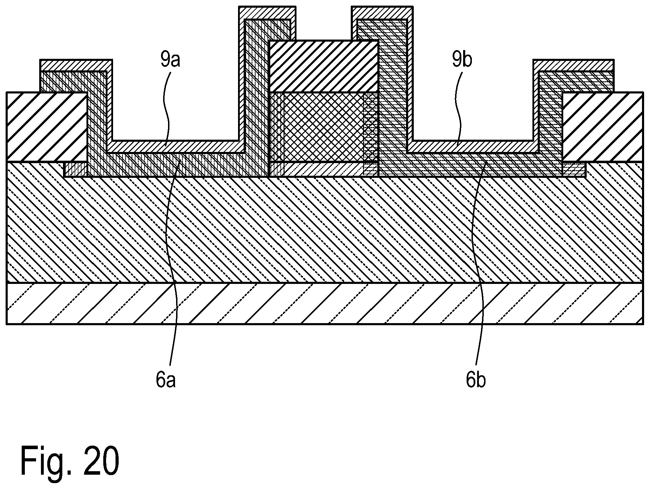

Die Figuren 20 und 21 illustrieren die Fertigstellung der zweiten Ausführungsform der erfindungsgemäßen Ge-PIN-Fotodiode. Im Unterschied zum Herstellungsprozess der ersten Ausführungsform kann auf Bildung der Spacer 8a (siehe Fig. 9) hier verzichtet werden, da durch gleichzeitiges Fehlen des nichtdotierten Si-Gebietes 6 der für die erste Ausführungsform angedeutete Leckstrom-Mechanismus völlig vermieden wird. Durch diesen Verzicht kann Metall-Silizid auch an mehr oder weniger senkrechten Teilen der dotierten Si-Schichten 6a und 6b gebildet werden, was den Metall-Silizid-Bedeckungsgrad über dotierten Si-Gebieten erhöht, wodurch sich der Dioden-Serienwiderstand reduzieren lässt.

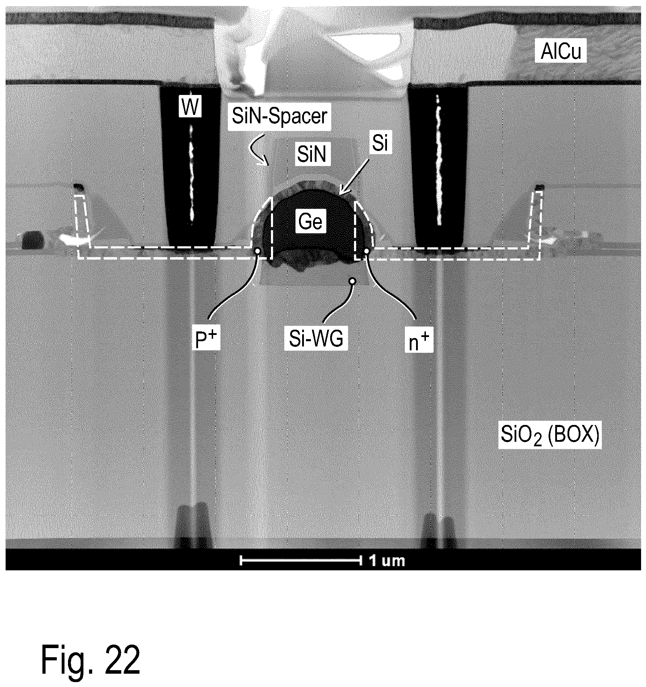

Figur 22 zeigt eine elektronenmikroskopische Querschnittsansicht einer PIN-Diode, die in ihrer Struktur dem in Fig. 1 schematisch dargestellten Ausführungsbeispiel entspricht. Zur Verdeutlichung der Lage der dotierten Silizium-Ausläufer sind gestrichelte Linien eingezeichnet. Die mit Si-WG gekennzeichnete Struktur bildet den Wellenleiter, die mit W gekennzeichnete Struktur ein Verbindungselement aus Wolfram.

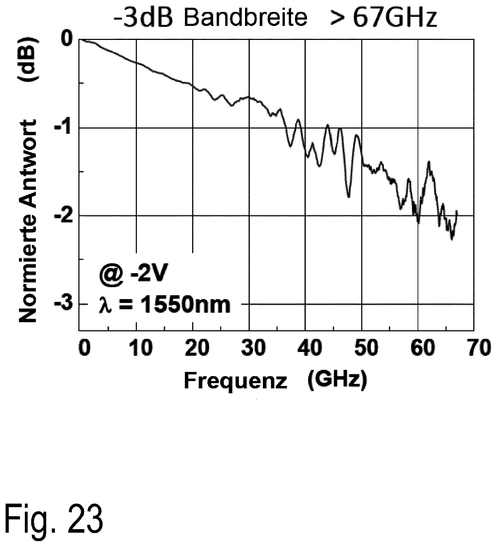

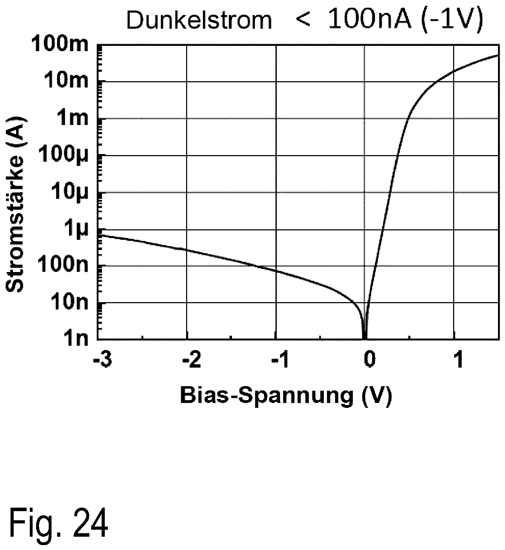

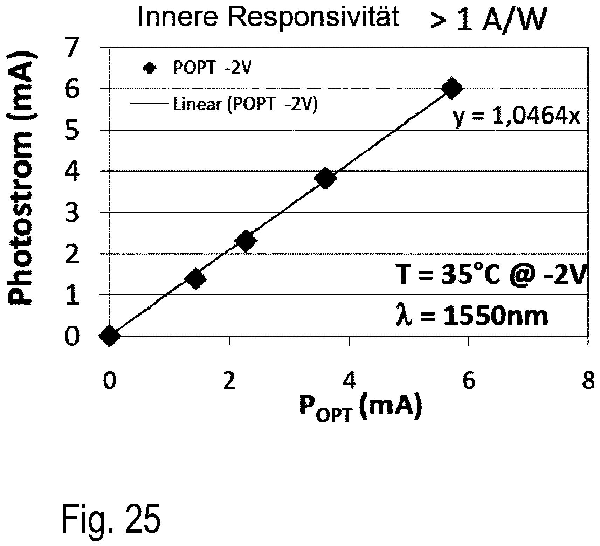

Die Figuren 23 bis 25 zeigen an einer Dioden-Struktur gemäß Figur 22 aufgenommene Messdaten, die die hohe Bandbreite (Figur 23), den geringen Dunkelstrom unter Betriebsbedingungen von maximal - 2 V (Figur 24) und die erzielte hohe Empfindlichkeit von > 1A/W bei einer Wellenlänge von 1550 nm und einer Betriebsspannung von -2V (Figur 25) belegen.

Zusammenfassend wird vorliegend eine Diode beschrieben, mit einem lichtempfindlichen Germanium-Gebiet, das sich auf einem Wellenleiter aus Silizium oder Siliziumgermanium befindet und das im Vergleich mit dem Wellenleiter identische oder um maximal 20 nm pro Seite kürzere laterale Abmessungen in einer Richtung quer zu einer Lichtausbreitungsrichtung im Wellenleiter hat.

## Patentansprüche

1. Diode mit einem lichtempfindlichen Germanium-Gebiet, das sich auf einem Wellenleiter (2) aus Silizium oder Siliziumgermanium befindet und das im Vergleich mit dem Wellenleiter identische oder um maximal 20 nm pro Seite kürzere laterale Abmessungen in einer Richtung quer zu einer Lichtausbreitungsrichtung im Wellenleiter hat, wobei
- die Diode im Germanium-Gebiet eine laterale Anordnung eines N-dotierten (5b), eines intrinsischen (5) und eines P-dotierten (5a) Germanium-Gebiets enthält,
- die P-dotierten und die N-dotierten Germanium-Gebiete von einer Oberfläche des Germanium-Gebiets bis an eine Oberkante des Wellenleiters (2) jeweils Dotierelemente aufweisen, an die optional zusätzlich darunter befindliche P- und N-dotierte Wellenleiter-Gebiete (2a, 2b) des Wellenleiters anschließen können, und sich P- (5c) und N-Dotierfronten (5d), getrennt durch das intrinsische Gebiet (5), parallel gegenüberstehen,
- sich entweder nur an die P- und N-dotierten Gebiete (5a, 5b) im Germanium-Gebiet oder sich an die P- und N-dotierten Germanium-Gebiete (5a, 5b) und gegebenenfalls zusätzlich an die darunter befindlichen P- und N-dotierte Wellenleiter-Gebiete (2a, 2b) des Wellenleiters (2) homogen dotierte Ausläufer (6a, 6b), welche aus Silizium oder Siliziumgermanium jeweils gleichen Leitungstyps bestehen, zur Kontaktierung des Germanium-Gebiets seitlich anschließen und sich in vertikaler Richtung mindestens bis zu einem Niveau erstrecken, welches auf gleicher Höhe ist, wie der in der vertikalen Richtung höchste Punkt des Germanium-Gebiets, sodass das Germanium-Gebiet seitlich mit Silizium oder Siliziumgermanium bedeckt ist.

2. Diode nach Anspruch 1, bei der die Ausläufer sich in seitlicher Richtung vom Germanium-Gebiet bis zu einem von einem Isolator (4) begrenzten Dioden-Rand erstrecken und auf einer Silizium-Oxid-Schicht (3) aufliegen.

3. Diode nach Anspruch 2, bei der Metall-Silizid-Schichten (9a, 9b) zumindest horizontal, also in seitlicher Richtung verlaufende Schichtteile der Ausläufer (6a, 6b) bedecken.

4. Diode nach Anspruch 3, die vertikal verlaufende Metallverbindungen (11) enthält, welche die Metall-Silizid-Schichten (9a, 9b) mit Metallstrukturen (12) verbinden, die in einer ersten horizontalen strukturierten Metallebene angeordnet sind und das Anlegen einer Betriebsspannung an die Diode ermöglichen.

5. Diode nach mindestens einem der Ansprüche 1 bis 4, bei der das Germanium-Gebiet von einer Silizium-Schicht (6) bedeckt ist, die eine Schichtdicke im Bereich zwischen 20 nm und 150 nm hat.

6. Diode nach Anspruch 5, die direkt oberhalb des intrinsischen Germanium-Gebiets (5) oder eines daran nach oben hin anschließenden intrinsischen Silizium-Gebiets der Silizium-Schicht (6) mit einem Isolator-Schicht-Streifen (7) bedeckt ist, dessen Dicke zwischen 50 nm und 500 nm beträgt und dessen laterale Abmessung gleich oder bis zu etwa 50 % geringer ist als die gesamte laterale Ausdehnung des lichtempfindlichen Germanium-Gebietes, wobei ein seitlicher Überstand des Germanium-Gebiets gegenüber dem Isolator-Schicht-Streifen (7) auf beiden Seiten annähernd gleich ist.

7. Diode nach Anspruch 6, bei der an den Isolator-Schicht-Streifen (7) seitlich Abstandshalter (8a) aus isolierendem Material, insbesondere aus Silizium-Nitrid anschließen.

8. Diode nach mindestens einem der Ansprüche 5 bis 7, bei der eine gesamte Höhe der Diode, gemessen in vertikaler Richtung von einer unteren Grenzfläche zwischen dem Germanium-Gebiet und dem darunter liegendem Wellenleiter (2) bis zu einer vom Germanium-Gebiet abgewandten Oberseite der es bedeckenden Silizium-Schicht (6), höchstens 700 nm beträgt.

9. Diode nach Anspruch 8, bei der die gesamte Höhe höchstens 500 nm beträgt.

10. Optoelektronisches Bauelement, mit einer Diode nach mindestens einem der vorstehenden Ansprüche und einer weiteren optischen oder optoelektronischen Komponente, die über den Wellenleiter (2) mit der Diode in optischer Kommunikation steht.

11. Optoelektronisches Bauelement nach Anspruch 10, bei dem die weitere optische oder optoelektronische Komponente mindestens ein Lichtemitter, mindestens ein Koppler zur Ein- oder Auskopplung von Licht in den Wellenleiter, mindestens ein Lichtmodulator ist oder eine Kombination mindestens zweier der genannten Komponenten ist.

## Claims

1. Diode comprising a light-sensitive germanium region, which is located on a waveguide (2) made of silicon or silicon germanium and which has lateral dimensions in a direction transverse to a direction of light propagation in the waveguide that are identical or at most 20 nm per side shorter in comparison with the waveguide, wherein
- in the germanium region, the diode contains a lateral arrangement of an n-doped (5b), an intrinsic (5) and a p-doped (5a) germanium region,
- the p-doped and the n-doped germanium regions each have doping elements extending from a surface of the germanium region to an upper edge of the waveguide (2) and which optionally can be contacted by p- and n-doped waveguide regions (2a, 2b) of the waveguide located thereunder, and p- (5c) and n-doping fronts (5d), separated by the intrinsic region (5), run parallel opposite each other,
- homogenously doped extensions (6a, 6b), which are made of silicon or silicon germanium of the same conductive type, extending vertically to at least a level at the same height as the vertically highest point of the germanium region so that the germanium region is covered laterally with silicon or silicon germanium, laterally adjoin for contacting the germanium region either only the p- and n-doped regions (5a, 5b) in the germanium region, or the p- and n-doped germanium regions (5a, 5b), and additionally, if present, the p- and n-doped waveguide regions (2a, 2b) of the waveguide (2) located thereunder.

2. Diode according to claim 1, wherein the extensions extend in the lateral direction from the germanium region to a diode edge defined by an insulator (4) and lie on top of a silicon oxide layer (3).

3. Diode according to claim 2, wherein the metal silicide layers (9a, 9b) cover at least layer parts of the extensions (6a, 6b) extending horizontally, that is in the lateral direction.

4. Diode according to claim 3, containing vertically extending metal connectors (11) which connect the metal silicide layers (9a, 9b) to metal structures (12) which are arranged in a first horizontal structured metal plane and which allow an operating voltage to be applied to the diode.

5. Diode according to at least one of claims 1 to 4, wherein the germanium region is covered by a silicon layer (6) having a layer thickness ranging between 20 nm and 150 nm.

6. Diode according to claim 5, covered directly above the intrinsic germanium region (5) or an upwardly adjoining intrinsic silicon region of the silicon layer (6) with an insulating strip (7), the thickness of which is between 50 nm and 500 nm and the lateral dimensions of which are equal to or up to approximately 50% less than the total lateral extension of the light-sensitive germanium region, wherein a lateral protrusion of the germanium region relative to the insulating strip (7) is approximately equal on both sides.

7. Diode according to claim 6, wherein spacers (8a) made of an insulating material, in particular of silicon nitride, laterally adjoin the insulating strip (7).

8. Diode according to at least one of claims 5 to 7, wherein a total height of the diode, measured in the vertical direction from a lower interface between the germanium region and the waveguide (2) thereunder to a top side of the silicon layer (6) covering it, said top side facing away from the germanium region, is at most 700 nm.

9. Diode according to claim 8, wherein the total height is 500 nm at most.

10. Optoelectronic component comprising a diode according to at least one of the preceding claims and an additional optical or optoelectronic component which is in optical communication with the diode via the waveguide (2).

11. Optoelectronic component according to claim 10, wherein the additional optical or optoelectronic component is at least a light emitter, at least a coupler for coupling light into or out of the waveguide, at least a light modulator or a combination of at least two of the aforesaid components.

## Revendications

1. Diode avec une région de germanium photosensible, qui se trouve sur un guide d'ondes (2) en silicium ou en silicium-germanium et qui présente, par rapport au guide d'ondes, des dimensions latérales identiques ou plus courtes de maximum 20 nm par côté, dans une direction transversale par rapport à une direction de propagation de la lumière dans le guide d'ondes,
- la diode dans la région de germanium contenant une disposition latérale d'une région de germanium dopée N (5b), d'une région de germanium intrinsèque (5) et d'une région de germanium dopée P (5a),
- les régions de germanium dopée P et dopée N comprenant chacune, d'une surface de la région de germanium jusqu'à un bord supérieur du guide d'ondes (2), des éléments de dopage auxquels peuvent se raccorder en option en outre des régions de guide d'ondes dopées P et dopées N (2a, 2b) du guide d'ondes et les fronts de dopage P (5c) et N (5d), se faisant face de manière parallèle, séparés par la région intrinsèque (5),
- les extrémités dopées de manière homogène (6a, 6b), qui sont constituées de silicium ou de silicium-germanium du même type de conduction, se raccordant latéralement, pour le contact de la région de germanium, soit uniquement aux régions dopées P et N (5a, 5b) de la région de germanium soit aux régions de germanium dopées P et N (5a, 5b) et le cas échéant en outre aux régions du guide d'ondes (2) dopées P et N (2a, 2b) se trouvant en dessous, et s'étendant en direction verticale au moins jusqu'à un niveau qui est à la même hauteur que le point le plus élevé, dans la direction verticale, de la région de germanium, de façon à ce que la région de germanium soit recouverte latéralement avec du silicium ou du silicium-germanium.

2. Diode selon la revendication 1, dans laquelle les extrémités s'étendent dans la direction latérale de la région de germanium jusqu'à un bord de diode limité par un isolateur (4) et reposent sur une couche d'oxyde de silicium (3).

3. Diode selon la revendication 2, dans laquelle des couches de métal-siliciure (9a, 9b) recouvrent au moins des parties de couches s'étendant horizontalement, donc dans la direction latérale, des extrémités (6a, 6b).

4. Diode selon la revendication 3, qui contient des composés métalliques (11) s'étendant verticalement, qui relient les couches de métal-siliciure (9a, 9b) avec des structures métalliques (12), qui sont disposées dans un premier plan métallique structuré horizontal et qui permettent l'application d'une tension de service à la diode.

5. Diode selon au moins l'une des revendications 1 à 4, dans laquelle la région de germanium est recouverte d'une couche de silicium (6) qui présente une épaisseur de l'ordre de 20 nm à 150 nm.

6. Diode selon la revendication 5, qui est recouverte, directement au-dessus de la région de germanium intrinsèque (5) ou d'une région de silicium intrinsèque, s'y raccordant vers le haut, de la couche de silicium (6), avec une bande de couche d'isolateur (7) dont l'épaisseur est de 50 nm à 500 nm et dont la dimension latérale est égale ou jusqu'à 50 % inférieure à l'extension latérale totale de la région de germanium photosensible, un surplomb latéral de la région de germanium par rapport à la bande de couche d'isolateur (7) étant approximativement identique des deux côtés.

7. Diode selon la revendication 6, dans laquelle, des entretoises (8a) en matériau isolant, plus particulièrement en nitrure de silicium, se raccordent latéralement aux bandes de couches d'isolateur (7).

8. Diode selon au moins l'une des revendications 5 à 7, dans laquelle une hauteur totale de la diode, mesurée dans la direction verticale à partir d'une surface limite inférieure entre la région de germanium et le guide d'ondes (2) se trouvant en dessous jusqu'à un côté supérieur, opposée à la région de germanium, de la couche de silicium (6) qui la recouvre, est de 700 nm maximum.

9. Diode selon la revendication 8, dans laquelle la hauteur totale est de 500 nm maximum.

10. Composant optoélectronique, avec une diode selon au moins l'une des revendications précédentes et un autre composant optique ou optoélectronique, qui est en communication optique avec la diode par l'intermédiaire du guide d'ondes (2).

11. Composant optoélectronique selon la revendication 10, dans lequel l'autre composant optique ou optoélectronique est au moins un émetteur de lumière, au moins un coupleur pour l'entrée ou la sortie de la lumière dans ou hors du guide d'ondes, au moins un modulateur de lumière ou une combinaison d'au moins deux des composants mentionnés.
